# EUROPEAN PATENT APPLICATION

(11) **EP 4 379 464 A1**
(43) Date of publication of application: **05.06.2024**
(21) Application number: 22849593.3
(22) Date of filing: 28.07.2022
(51) Int. Cl.: G03F 1/62, G03F 7/20

(54) **PELLICLE FILM, PELLICLE, EXPOSURE ORIGINAL PLATE WITH PELLICLE, EXPOSURE METHOD, SEMICONDUCTOR MANUFACTURING METHOD, AND LIQUID CRYSTAL DISPLAY PANEL MANUFACTURING METHOD**

(30) Priority: 30.07.2021 JP 2021124967
(71) Applicant: SHIN-ETSU CHEMICAL CO., LTD., Tokyo 1000005 (JP)
(72) Inventor: NISHIMURA, Akinori, Annaka-shi, Gunma 379-0127 (JP); SHIRASAKI, Toru, Annaka-shi, Gunma 379-0127 (JP)
(74) Representative: Meissner Bolte Partnerschaft mbB
(86) International application number: PCT/JP2022/029162
(87) International publication number: WO 2023/008532

(57) **Abstract**

The present invention provides: a pellicle film including a film (BNNT film) having boron nitride nanotubes; and a pellicle for photolithography including a pellicle film and a pellicle frame, wherein the pellicle film is provided on one end surface of the pellicle frame via an adhesive, and the pellicle film includes a BNNT film. According to the present invention, it is possible to provide: a pellicle film which has a high permeation for EUV exposure, has excellent heat resistance and durability, and has hydrogen radical resistance; and a pellicle provided with the same.

## Description

### TECHNICAL FIELD

This invention relates to a pellicle membrane and a pellicle comprising the membrane, the pellicle being mounted on a lithographic photomask as a dust cover in the manufacture of semiconductor devices such as LSI and VLSI and liquid crystal display panels.

### BACKGROUND ART

The development of exposure technology known as photolithography enabled high integration of semiconductor editing circuits.

In the exposure process which is commercially applied at the present, an exposure equipment utilizing an ArF wavelength band of 193 nm is used to forward the transfer step to form a small-size pattern on a wafer. Since a limit is imposed on the formation of small-size patterns of 32 nm or less, a variety of solutions including double exposure, phase transfer and optical phase correction are developed. The exposure technology using ArF wavelength, however, is difficult to accomplish further miniaturization, specifically a circuit line width of 32 nm or less. Under the circumstances, attention is paid as the next generation step to the EUV photolithography using extreme ultraviolet (referred to as EUV, hereinafter) having a shorter wavelength of 13.5 nm than the wavelength of 193 nm as the main exposure wavelength.

On the other hand, the photolithography process uses a photomask as the patterning original to transfer the pattern on the photomask to a wafer. If contaminants such as particles and dust are deposited on the photomask, exposure radiation is absorbed or reflected by the contaminants whereby the transferred pattern is deformed or damaged. This invites reductions of the performance and yield of semiconductor devices.

For the purpose of preventing contaminants from depositing on the surface of photomasks, it becomes a common practice to mount a pellicle on a photomask. In general, the pellicle is placed on the upper surface of the photomask. Even if contaminants deposit on the pellicle, the focus in the photolithography process is off dust or foreign particles on the pellicle because the focus is kept in register with the pattern on the photomask. The contaminants are not transferred to the pattern. Recently, the size of contaminants that can affect damaging of the pattern is reduced in compliance with the miniaturization of circuit line width. The role of pellicle is regarded more important for protecting the photomask.

In the case of a pellicle composed of a single membrane wherein a material having a low coefficient of extinction with respect to EUV radiation of 13.5 nm is applied, it is easy to acquire a transmittance, but it is quite difficult to acquire satisfactory mechanical and thermal properties.

When the pellicle membrane is exposed to EUV, the membrane absorbs part of the energy. The energy of EUV absorbed in the membrane is converted to heat via a variety of relaxation steps. Accordingly, the temperature of the pellicle membrane rises during EUV exposure. The pellicle membrane is thus required to have high heat release and heat resistance.

Patent Document 1 describes a pellicle membrane of single crystal silicon. The single crystal silicon membrane, however, has poor heat release and a low melting point. This raises a problem that the pellicle membrane is susceptible to damage upon EUV exposure.

Patent Document 2 describes a pellicle membrane of graphene. Since graphene is an aggregate of small size crystals, the pellicle membrane is brittle and insufficient in durability. Even when multiple layers of graphene are stacked, it is difficult to guarantee satisfactory strength to the pellicle membrane.

Further, Patent Document 3 proposes a pellicle membrane of carbon nanotubes. Since the CNT pellicle membrane has no resistance to hydrogen radicals which generate in the EUV exposure step, it is necessary to coat the surface and voids of the CNT pellicle membrane with a suitable material. The manufacturing process is thus cumbersome.

### PRIOR ART DOCUMENTS

### PATENT DOCUMENTS

Patent Document 1: JP-A 2010-256434
Patent Document 2: WO 2019/176410
Patent Document 3: JP-A 2018-194838

### SUMMARY OF INVENTION

### TECHNICAL PROBLEM

An object of the invention, which has been made under the above-mentioned circumstances, is to provide a pellicle membrane having a high transmittance during EUV exposure, satisfactory heat resistance, durability and resistance to hydrogen radicals, and a pellicle comprising the pellicle membrane.

### SOLUTION TO PROBLEM

Making extensive investigations to attain the above object, the inventors have found that when boron nitride nanotubes (BNNTs) is selected as the material of a pellicle membrane for EUV lithography, the pellicle membrane has heat resistance and mechanical stability compared to CNTs and is stable against hydrogen radicals without a need to coat the pellicle membrane surface with a special material. The invention is predicated on this finding.

Accordingly, the invention provides a pellicle membrane, pellicle, pellicle-mounted exposure original, exposure method, method for manufacturing a semiconductor device, and method for manufacturing a liquid crystal display panel, as defined below.
1. A pellicle membrane comprising a membrane (BNNT membrane) having boron nitride nanotubes.
2. The pellicle membrane of 1 wherein the BNNT membrane contains a mesh, web or grid having bundles of BNNTs.
3. The pellicle membrane of 1 or 2 wherein the thickness of the BNNT membrane accounts for at least 90% of the overall thickness of the pellicle membrane.
4. The pellicle membrane of any one of 1 to 3, having a transmittance of at least 80% with respect to light of wavelength 13.5 nm.
5. The pellicle membrane of any one of 1 to 4 which is used in lithography using extreme ultraviolet (EUV) radiation of wavelength 13.5 nm as the main exposure wavelength.
6. A pellicle for photolithography comprising a pellicle membrane and a pellicle frame, the pellicle membrane being attached to one end surface of the pellicle frame via an adhesive, wherein the pellicle membrane is of any one of 1 to 5.
7. A pellicle-mounted exposure original comprising an exposure original and the pellicle of 6 mounted thereon.
8. The pellicle-mounted exposure original of 7 wherein the exposure original is an exposure original for EUV lithography.
9. An exposure method comprising the step of exposure through the pellicle-mounted exposure original of 8.
10. A method for manufacturing a semiconductor device comprising the step of exposing a substrate to radiation through the pellicle-mounted exposure original of 7 under vacuum or reduced pressure.
11. A method for manufacturing a liquid crystal display panel comprising the step of exposing a substrate to radiation through the pellicle-mounted exposure original of 7 under vacuum or reduced pressure.
12. A method for manufacturing a semiconductor device comprising the step of exposing a substrate to EUV through the pellicle-mounted exposure original of 7.
13. A method for manufacturing a liquid crystal display panel comprising the step of exposing a substrate to EUV through the pellicle-mounted exposure original of 7.

### ADVANTAGEOUS EFFECTS OF INVENTION

According to the invention, there are provided a pellicle membrane exhibiting a high transmittance upon EUV exposure and having satisfactory heat resistance, durability and resistance to hydrogen radicals, and a pellicle comprising the pellicle membrane.

### DESCRIPTION OF EMBODIMENTS

Now the invention is described in detail.

The pellicle membrane of the invention is a membrane composed of boron nitride nanotubes (BNNTs). The membrane having boron nitride nanotubes is abbreviated as "BNNT membrane," hereinafter. The BNNT membrane should preferably comprise at least 90% by weight, more preferably at least 95% by weight, even more preferably at least 98% by weight of boron nitride nanotubes. Most preferably, the membrane consists essentially of boron nitride nanotubes because the benefits of the invention are obtained to the maximum. As used herein, a membrane "consisting essentially of boron nitride nanotubes" means that the membrane excluding catalysts and impurities is entirely composed of boron nitride nanotubes. The boron nitride nanotubes may form a composite with various other materials such as carbon nanotubes as long as the benefits of the invention are available.

It is noted that in the context of this disclosure, the term "BNNT membrane" refers to a mesh, web, grid or other arrangement of linked BNNTs formed of separate BNNTs or bundles of BNNTs. Separate BNNTs (single-walled BNNTs or multi-walled BNNTs (MWBNNTs)) in the BNNT membrane may be arrayed to form bundles. There is a tendency that such bundles of arrayed BNNTs spontaneously form during the manufacture of BNNT membranes.

The BNNTs or BNNT bundles in the BNNT membrane may be randomly arranged in the BNNT membrane. However, the BNNTs or BNNT bundles in the BNNT membrane may also be arranged or arrayed in an important or major direction or in plural major directions.

The BNNTs in the BNNT membrane may be either single-walled BNNTs (SWBNNTs) or multi-walled BNNTs (MWBNNTs). Accordingly, the BNNT membrane may be formed of SWBNNTs or bundles of SWBNNTs, or MWBNNTs or bundles of MWBNNTs.

One exemplary method of preparing a BNNT membrane is described below.

### <Preparation of BNNT membrane>

BNNTs may be synthesized using the floating catalyst CVD method. BNNTs can be synthesized by using amine borane borazine (B₃N₃H₆) or decaborane (B₁₀H₁₄) as a starting material and reacting it with nickelocene in ammonia at 1,200 to 1,300°C. While the BNNTs thus synthesized are deposited on a hydrophobic filter, they agglomerate together due to the intermolecular forces or van der Waals forces therebetween, to form a membrane. Using a second support different from a pellicle frame, the BNNT membrane deposited on the filter is peeled. Then the BNNT membrane is transferred from the support to a pellicle frame. Specifically, a silicone-based pressure-sensitive adhesive (for example, KE-101A/B by Shin-Etsu Chemical Co., Ltd.) applied to the upper end surface of the pellicle frame is heat cured and contacted with the BNNT membrane stretched on the support (within the support). After the upper end surface of the pellicle frame is attached to the BNNT membrane stretched on the support which is larger than the pellicle frame, the portion of the BNNT membrane extending outside the pellicle frame is removed, completing the pellicle.

BNNTs can also be synthesized by grinding boron powder on a ball mill, and subjecting the ground boron to thermal CVD reaction with ammonia at 1,100°C in the presence of a metal oxide catalyst such as Fe₂O₃, Ga₂O₃, MgO or Li₂O, or in the presence of metallic iron and nickel boride. The BNNTs thus synthesized agglomerate together due to the intermolecular forces therebetween, to form a membrane on a Si substrate. Like the floating catalyst CVD method, the BNNT membrane deposited by this method may be transferred to a second support and eventually to a pellicle frame.

Further, BNNTs can be prepared by arc discharge, laser evaporation, and dispersion filtration methods although the method is not limited thereto. BNNTs can be prepared by any methods well-known in the art. For example, a BNNT membrane which is suitable for use in embodiments of the invention may be prepared as described in WO 2019/006549, "Method for preparing superhydrophobic nano-microscale patterned films" and then converted to a self-standing membrane through a transfer step.

Since the BNNT membrane used herein has high resistance to hydrogen radicals, a protective film often formed on a carbon nanotube membrane (CNT membrane) or coating on tubes is unnecessary. Such a protective film or coating can be applied to the inventive BNNT membrane. If so, such film or coating may be formed to a minimum thickness. Then the proportion of the thickness of the BNNT membrane in the thickness of the pellicle membrane can be set 90% or more. Even the pellicle membrane consisting essentially of the BNNT membrane can function as a pellicle membrane for the EUV lithography.

The protective film is formed on one surface or both surfaces of the BNNT membrane. A protective film containing at least one component selected from the group consisting of SiOₓ wherein x ≤ 2, SiₐN_{b} wherein a/b is from 0.7 to 1.5, SiON, Y₂O₃, YN, Mo, Ru, Rb, Sr, Y, Zr, Nb, B₄C, SiC and Rh is exemplary. As the coating, any of the components mentioned for the protective film may be used.

When the surface of the BNNT membrane is observed by a scanning electron microscope (SEM)-energy dispersive X-ray (EDX) spectrometer, the BNNT membrane may include a region where the proportion of B element, N element and catalyst-constituting elements is at least 90 mol% of the elements observed. Even the BNNT membrane consisting essentially of B element, N element and catalyst-constituting elements can function as a pellicle membrane for the EUV lithography. The catalyst-constituting elements may be removed by heat treatment and in this case, the aforementioned proportion is the proportion of B and N elements.

Referring to the observation by SEM-EDX, judgment may be made by mapping an SEM-EDX image of the BNNT membrane surface measured at a magnifying power of 1000× to 4000×. In one exemplary measurement of SEM-EDX image, measurement may be carried out under the settings: an accelerating voltage of 10 kV, an emission current of 1 µA, a measurement pixel number of 256x256 pixels, and a number of 50 transients. To prevent a sample from electrostatic charging, the surface may be treated with gold, platinum or osmium by vacuum evaporation or sputtering. For the analysis of an SEM-EDX image, luminance and contrast are preferably adjusted such that no pixels reach the maximum luminance and the average of brightness falls in a range of luminance 40 to 60%.

The inventive pellicle membrane has a transmittance of preferably at least 80%, more preferably at least 90% of EUV radiation (wavelength 13.5 nm). The transmittance may be measured by a standard transmittance meter.

A conventional pellicle is composed of a pellicle frame, pellicle membrane, pellicle membrane bonding layer, pressure-sensitive adhesive (PSA) layer for photomask substrate or exposure original (referred to as mask PSA layer, hereinafter), ventilating port, and filter. Typically, a separator may be attached to the pellicle to protect the surface of the mask PSA layer.

The size of the pellicle membrane is selected as appropriate depending on the size of a pellicle frame. The pellicle membrane typically has a thickness of from 10 to 200 nm.

When the pellicle membrane is attached to the pellicle frame, an adhesive may be used. Exemplary adhesives include acrylic resin adhesives, epoxy resin adhesives, silicone resin adhesives, and adhesives based on fluorinated polymers such as fluorinated silicone. From the aspect of heat resistance, silicone adhesives are preferred. The adhesive is diluted with a solvent if necessary, and applied to the upper end surface of the pellicle frame. As the application method used herein, any of brush coating, spraying and automatic dispenser may be employed.

The mask PSA layer for mounting the pellicle on the mask substrate may be formed of any of well-known PSAs such as double side PSA tape, silicone-based PSAs, and acrylic PSAs. Typically, the pellicle frame is provided at its lower end surface with a mask PSA layer, and a separator is releasably attached thereto.

The material of which the pellicle frame is made is not particularly limited and any of well-known materials may be used. Since the EUV lithography requires a higher accuracy than the ArF lithography, a severer requirement is imposed on the flatness of the photomask used therein. It is known that the flatness of the photomask is affected by the pellicle. To suppress more or less the influence of the pellicle on the photomask, it is preferred to use a light-weight metal such as titanium, titanium alloy, aluminum or aluminum alloy.

The size of the pellicle frame is not particularly limited. When the height of EUV lithography pellicle is limited to 2.5 mm or less, the thickness of the EUV lithography pellicle frame is less than that height, preferably 2.5 mm or less. In particular, the thickness of the EUV lithography pellicle frame is preferably 1.5 mm or less when the thickness of the pellicle membrane and photomask PSA is taken into account. The lower limit of the thickness of the pellicle frame is preferably 1.0 mm or more.

The pellicle frame may be provided with ventilating ports or recessed portions for accommodating changes of atmospheric pressure inside and outside the pellicle. In this embodiment, a filter may be provided for preventing passage of foreign particles through the ventilating ports.

To the lower end surface of the mask PSA on the pellicle frame, a release layer or separator may be attached for protecting the PSA. While the material of the release layer is not particularly limited, use may be made of polyethylene terephthalate (PET), polytetrafluoroethylene (PTFE), tetrafluoroethylene-perfluoroalkyl vinyl ether copolymers (PFA), polyethylene (PE), polycarbonate (PC), polyvinyl chloride (PVC), and polypropylene (PP), for example. Also, if necessary, such release agents as silicone-based release agents and fluorochemical release agents may be coated on the surface of the release layer.

The pellicle frame may be provided with an outward or inward projection. When such a projection is used, the filter may be formed in the projection. When the outward projection is provided with a connection means (e.g., screw or PSA) to an exposure original, the PSA for the photomask may be omitted.

The pellicle of the invention may serve not only as a protective member for protecting an exposure original from particulate contamination in an EUV aligner, but also as a protective member for protecting an exposure original during its storage or transportation. In preparing a pellicle-mounted exposure original by mounting a pellicle on an exposure original, typically photomask, an electrostatic chucking method, mechanical securing method or the like may be used as well as the aforementioned method of bonding with the photomask PSA.

A further embodiment of the invention is a method for manufacturing a semiconductor device or LC display panel, which includes the step of exposing a substrate (semiconductor wafer or LC matrix) to radiation through the pellicle-mounted exposure original. For example, in the lithography step which is one of the steps of the process of manufacturing a semiconductor device or LC display panel, the stepper is installed with the pellicle-mounted exposure original and exposure is performed to form a photoresist pattern corresponding to an integrated circuit or the like on a substrate. In general, a projection optical system is used in the EUV lithography such that EUV radiation is reflected by the exposure original and directed to the substrate. The exposure step is performed under reduced pressure or vacuum. Even when contaminants deposit on the pellicle in the lithography step, the contaminants are out of focus on the photoresist-coated wafer, preventing the images of contaminants from causing short- or open-circuiting in the integrated circuit. Therefore, the yield of the lithography step can be improved by using the pellicle-mounted exposure original.

### EXAMPLES

Examples and Comparative Examples are given below for illustrating the invention, but the invention is not limited thereto.

### [Example 1]

BNNTs were synthesized by using amine borane borazine (B₃N₃H₆) as a starting material and reacting it with nickelocene in ammonia at 1,200 to 1,300°C. The BNNTs thus synthesized were deposited on a hydrophobic filter (trade name "Advantec Membrane/T020A-293D" by Sansyo Co., Ltd.), to form a multilayer BNNT membrane. Next, using a silicon frame obtained by working a silicon wafer as a support, the BNNT membrane deposited on the filter was peeled. An acrylic PSA (SK-1499M by Soken Chemical & Engineering Co., Ltd.) was applied to the one end surface of the support and cured. With the PSA forced against the BNNT membrane, the membrane was obliquely peeled at a peeling rate of 0.1 mm/s. Thereafter, the BNNT membrane was transferred from the support to a pellicle frame. The pellicle frame used herein was a pellicle frame of titanium having an outer size of 118.3 mm × 150.8 mm × 1.5 mm and an inner size of 142.8 mm × 110.3 mm × 1.5 mm. After a silicone PSA (KE-101A/B by Shin-Etsu Chemical Co., Ltd.) was applied to the upper end surface of the pellicle frame and heat cured, it was contacted with the BNNT membrane stretched on the support (within the support). After the upper end surface of the pellicle frame was attached to the BNNT membrane stretched on the support which was larger than the pellicle frame, the portion of the BNNT membrane extending outside the pellicle frame was removed, completing the pellicle.

### <Measurement of EUV transmittance>

EUV transmittance was measured as follows.

In an EUV irradiation unit (New SUBARU synchrotron radiation facility BL-10 by University of Hyogo), EUV radiation of wavelength 13.5 nm was irradiated to the pellicle. With the direction of EUV irradiation set perpendicular to the surface of the pellicle membrane, EUV was irradiated so as to scan over the pellicle membrane, during which EUV transmittance was measured. This resulted in an EUV transmittance of 95%.

### <EUV durability>

In an EUV irradiation unit (New SUBARU synchrotron radiation facility BL-9 by University of Hyogo), EUV radiation was irradiated to the pellicle under conditions: wavelength 13.5 nm, light source intensity 5 W/cm², and 3 hours. EUV durability was evaluated by observing the outer appearance of the pellicle before and after the durability test. As a result, the pellicle showed no changes of outer appearance before and after the durability test.

## Claims

1. A pellicle membrane comprising a membrane (BNNT membrane) having boron nitride nanotubes.

2. The pellicle membrane of claim 1 wherein the BNNT membrane contains a mesh, web or grid having bundles of BNNTs.

3. The pellicle membrane of claim 1 or 2 wherein the thickness of the BNNT membrane accounts for at least 90% of the overall thickness of the pellicle membrane.

4. The pellicle membrane of any one of claims 1 to 3, having a transmittance of at least 80% with respect to light of wavelength 13.5 nm.

5. The pellicle membrane of any one of claims 1 to 4 which is used in lithography using extreme ultraviolet (EUV) radiation of wavelength 13.5 nm as the main exposure wavelength.

6. A pellicle for photolithography comprising a pellicle membrane and a pellicle frame, the pellicle membrane being attached to one end surface of the pellicle frame via an adhesive, wherein the pellicle membrane is of any one of claims 1 to 5.

7. A pellicle-mounted exposure original comprising an exposure original and the pellicle of claim 6 mounted thereon.

8. The pellicle-mounted exposure original of claim 7 wherein the exposure original is an exposure original for EUV lithography.

9. An exposure method comprising the step of exposure through the pellicle-mounted exposure original of claim 8.

10. A method for manufacturing a semiconductor device comprising the step of exposing a substrate to radiation through the pellicle-mounted exposure original of claim 7 under vacuum or reduced pressure.

11. A method for manufacturing a liquid crystal display panel comprising the step of exposing a substrate to radiation through the pellicle-mounted exposure original of claim 7 under vacuum or reduced pressure.

12. A method for manufacturing a semiconductor device comprising the step of exposing a substrate to EUV through the pellicle-mounted exposure original of claim 7.

13. A method for manufacturing a liquid crystal display panel comprising the step of exposing a substrate to EUV through the pellicle-mounted exposure original of claim 7.
